# EUROPÄISCHE PATENTSCHRIFT

(11) **EP 2 842 082 B1**
(45) Veröffentlichungstag und Bekanntmachung des Hinweises auf die Patenterteilung: **14.12.2016**
(21) Anmeldenummer: 13725060.1
(22) Anmeldetag: 25.04.2013
(51) Int. Cl.: G06K 19/077

(54) **VERFAHREN ZUR HERSTELLUNG EINES SMARTCARD-KÖRPERS ZUR AUFNAHME EINES HALBLEITER-CHIPS SOWIE EIN DERARTIGER SMARTCARD-KÖRPER**
METHOD FOR PRODUCING A SMARTCARD BODY FOR RECEIVING A SEMICONDUCTOR CHIP AND SMARTCARD BODY OF THIS TYPE
PROCÉDÉ DE FABRICATION D'UN CORPS DE CARTE À PUCE DESTINÉ À RECEVOIR UNE PUCE DE SEMI-CONDUCTEUR, ET CORPS DE CARTE À PUCE CORRESPONDANT

(30) Priorität: 26.04.2012 DE 102012008176; 26.04.2012 DE 202012004102 U
(43) Veröffentlichungstag der Anmeldung: 04.03.2015
(73) Patentinhaber: pretema GmbH, 75223 Niefern (DE)
(72) Erfinder: DANIEL, Eric, 75223 Niefern (DE); EBERHARDT, Frank, 75223 Niefern (DE); KALCK, Sébastien, 75223 Niefern (DE); MORGENTHALER, Frédéric, 75223 Niefern (DE); MUTZ, Rainer, 75223 Niefern (DE); SCHABINGER, Timo, 75223 Niefern (DE)
(74) Vertreter: Leitner, Waldemar
(86) Internationale Anmeldenummer: PCT/EP2013/001245
(87) Internationale Veröffentlichungsnummer: WO 2013/159929

(56) Entgegenhaltungen:
- DE-A1-102008 033 018
- US-A- 5 438 481
- US-A1- 2005 174 767
- US-A1- 2008 017 972

## Beschreibung

Die Erfindung betrifft ein Verfahren zur Herstellung eines Smartcard-Körpers zur Aufnahme eines Halbleiter-Chips, wobei in einem Trägermaterial mindestens ein Lead-Frame des Smartcard-Körpers ausgebildet wird, der jeweils über mindestens einen Materialstreifen mit dem Trägermaterial verbunden ist, und bei dem ein elektrisch isolierendes Gehäuse mit einer Kavität zur Aufnahme des Halbleiter-Chips ausgebildet wird, indem der Lead-Frame zur Ausbildung des Smartcard-Körpers mit dem Gehäuse umgeben wird, sowie einen Smartcard-Körper zur Aufnahme eines Halbleiter-Chips, wobei der Smartcard-Körper einen Lead-Frame, der an einer ersten Oberfläche erste Kontaktflächen und einer zweiten Oberfläche zweite Kontaktflächen aufweist, die mit den Anschlüssen eines in eine Kavität des Smartcard-Körpers eingesetzten Halbleiter-Chips verbindbar sind.

Ein derartiges Verfahren zur Herstellung eines Smartcard-Körpers gemäß dem Oberbegriff des Anspruchs 1 sowie ein nach diesem Verfahren hergestellter Smartcard-Körper gemäß dem Oberbegriff des Anspruchs 8 sind aus der EP 1 785 916 bekannt. Die nach dem vorstehend beschriebenen Verfahren hergestellten Smartcard-Körper sind nach der Ausbildung des Gehäuses über Materialstreifen mit dem Trägermaterial verbunden, die aus dem Gehäuse des Smartcard-Körpers hervorstehen. Die den Smartcard-Körper mit dem Trägermaterial verbindenden Materialstreifen sind nicht von dem isolierenden Material des Gehäuses umhüllt und bilden daher in nachteiliger Art und Weise mögliche Korrosionsstellen aus. Nach dem Einsetzen des Halbleiter-Chips in den Smartcard-Körper zur Ausbildung einer Smartcard müssen diese Materialstreifen vom Hersteller der Smartcard durchtrennt werden, um die derart gebildete Smartcard aus dem Trägermaterial herauslösen zu können. Dies bringt aber in nachteiliger Art und Weise mit sich, dass der Hersteller der Smartcards zum Vereinzeln der Smartcards diesen Arbeitsgang durchführen muss, wodurch eine weitere Arbeitsstation zum Durchtrennen der Materialstreifen nach dem Einsetzen des Halbleiter-Chips in die Kavität des Smartcard-Körpers und deren Verschließen erforderlich wird.

Es ist Aufgabe der vorliegenden Erfindung, ein Verfahren zur Herstellung eines Smartcard-Körpers sowie einen derartigen Smartcard-Körper zu schaffen, der leichter aus dem Trägermaterial herauslösbar und keine korrosionsgefährdeten Stellen aufweist.

Diese Aufgabe wird durch ein Verfahren mit den Merkmalen des Anspruchs 1 sowie durch einen Smartcard-Körper gemäß den Merkmalen des Anspruchs 8 gelöst.

Durch die erfindungsgemäßen Maßnahmen werden in vorteilhafter Art und Weise ein Verfahren zur Herstellung eines Smartcard-Körpers sowie ein derartiger Smartcard-Körper geschaffen, welche sich dadurch auszeichnen, dass aus dem Gehäuse des Smartcard-Körpers keine Teile des Lead-Frames oder sonstige korrosionsgefährdete Elemente hervorstehen. Ein derartiger Smartcard-Körper zeichnet sich durch seine Langlebigkeit und Beständigkeit gegen Umwelteinflüsse aus. Die erfindungsgemäßen Maßnahmen besitzen den weiteren Vorteil, dass der erfindungsgemäße Smartcard-Körper leicht aus dem Trägermaterial lösbar ist, da eine Kraftbeaufschlagung desselben bewirkt, dass die den Smartcard-Körper mit dem Trägermaterial verbindenden Teile des Materialstreifens aus dem Gehäuse des Smartcard-Körpers herausgezogen werden, so dass der erfindungsgemäße Smartcard-Körper leicht vereinzelt werden kann. Das erfindungsgemäße Verfahren zeichnet sich dadurch aus, dass in einfacher Art und Weise durch ein Durchtrennen und Separieren der Materialstreifen die erfindungsgemäß vorgesehenen Zwischenräume ausgebildet werden können.

Eine vorteilhafte Weiterbildung des erfindungsgemäßen Verfahrens sieht vor, dass der zweite und/oder der erste Streifenteil des jeweiligen Materialstreifens verformt wird, um die zur Ausbildung des Zwischenraums zwischen diesen beiden Streifenteilen erforderliche räumliche Separierung der Enden der entsprechenden Streifenteile zu schaffen. Eine derartige Maßnahme besitzt den Vorteil, dass hierdurch in einfacher Art und Weise die Ausbildung des Zwischenraums zwischen zwei Streifenteilen eines jeweiligen Materialstreifens durchgeführt werden kann.

Eine weitere vorteilhafte Weiterbildung der Erfindung sieht vor, dass mindestens ein Materialstreifen mindestens eine Prägung aufweist. Eine derartige Maßnahme besitzt den Vorteil, dass hierdurch das Verformen des jeweiligen Streifenteils des Materialstreifens zur räumlichen Separation der Streifenteile und zur Ausbildung des Zwischenraums zwischen diesen erleichtert wird.

Weitere vorteilhafte Weiterbildungen der Erfindung sind Gegenstand der Unteransprüche.

Weitere Vorteile der Erfindung sind dem Ausführungsbeispiel zu entnehmen, das im folgenden anhand der Figuren beschrieben wird. Es zeigen:
- Figur 1:: eine Draufsicht auf eine erste Seite eines Trägermaterials,
- Figur 2:: eine Draufsicht auf das Trägermaterial der Figur 1 nach dem Trennen von Verbindungsstegen,

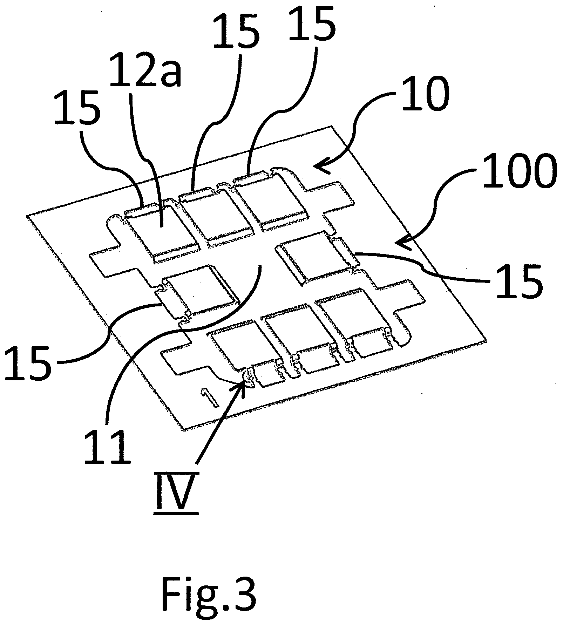

- Figur 3:: eine vergrößerte Darstellung des Smartcard-Körpers der Figur 2,
- Figur 4:: eine vergrößerte Darstellung des Bereichs IV der Figur 3,

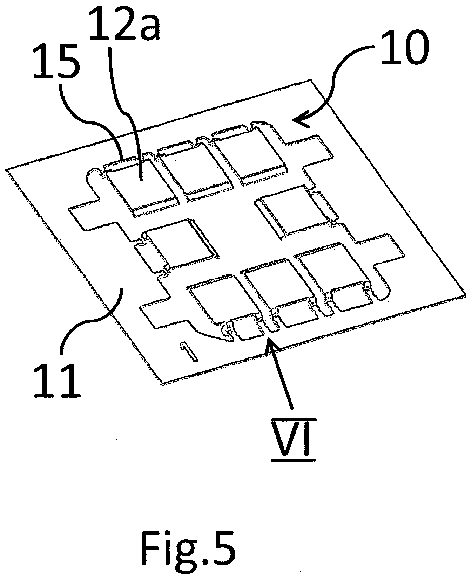

- Figur 5:: eine Darstellung des Smartcard-Körpers ohne Gehäuse,
- Figur 6:: eine vergrößerte Darstellung des Bereichs VI der Figur 5,
- Figur 7a und 7b:: Darstellungen der beiden Seiten eines Ausführungsbeispiels des Smartcard-Körpers, und
- Figur 8:: ein Schnitt durch den Smartcard-Körper der Figur 7a.

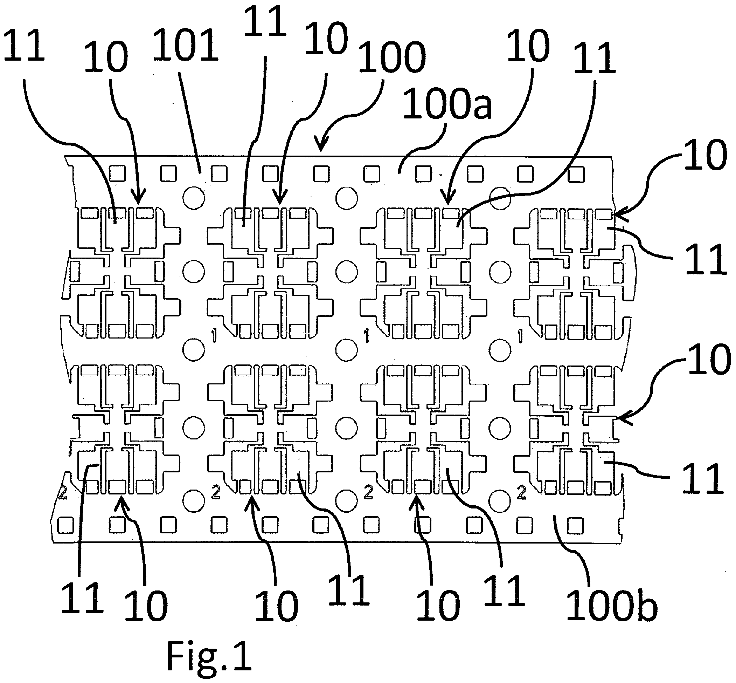

Das Verfahren zur Herstellung eines allgemein mit 10 bezeichneten Smartcard-Körpers wird anhand der Figuren beschrieben. Die Figur 1 zeigt eine Draufsicht auf eine erste Oberfläche 100a eines Trägermaterials 100. Wie aus dieser Figur ersichtlich, wird eine Vielzahl von Smartcard-Körpern 10 aus dem Trägermaterial 100 hergestellt. Das Trägermaterial 100 wird durch eine leitfähige Schicht 101 gebildet, die vorzugsweise aus einem Kupferblech besteht, wobei aber auch andere Materialien wie z. B. Aluminium möglich sind. Zuerst werden in an und für sich bekannter und daher nicht mehr näher beschriebenen Art und Weise aus dem Trägermaterial 100 Lead-Frames 11 ausgebildet, etwa durch Stanzen oder Ätzen. Wie die Figur 1 zeigt, ist beim beschriebenen Ausführungsbeispiel vorgesehen, dass innerhalb einer Breite des Trägermaterials 100 zwei Lead-Frames 11 für zwei Smartcard-Körper 10 vorgesehen sind. Es ist aber auch möglich, nur einen einzigen Lead-Fream 11 für eine Smartcard-Körper 10 oder mehr als zwei Lead-Frames 11 für die entsprechende Anzahl von Smartcard-Körpern 10 innerhalb der Breite des Trägermaterials 100 vorzusehen.

Es wird bevorzugt, dass das Trägermaterial 100 als ein bandförmiges Trägermaterial ausgebildet ist, welches vorzugsweise aus einer Rolle der leitfähigen Schicht 101 besteht, so dass eine Vielzahl von Lead-Frames 11 für die Smartcard-Körper 10 mittels eines Rolle-zu-Rolle-Verfahrens hergestellt werden können.

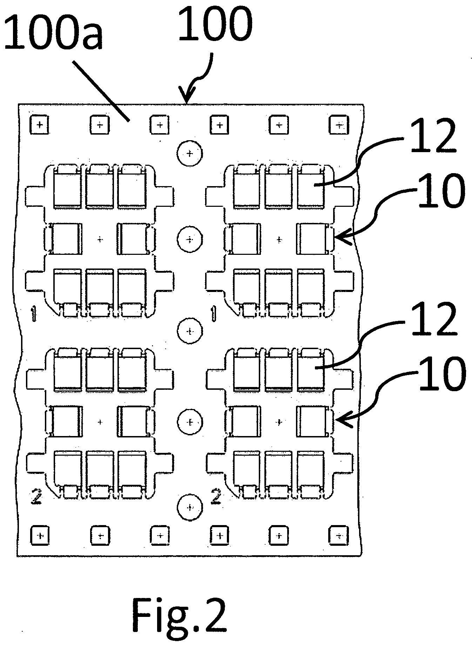

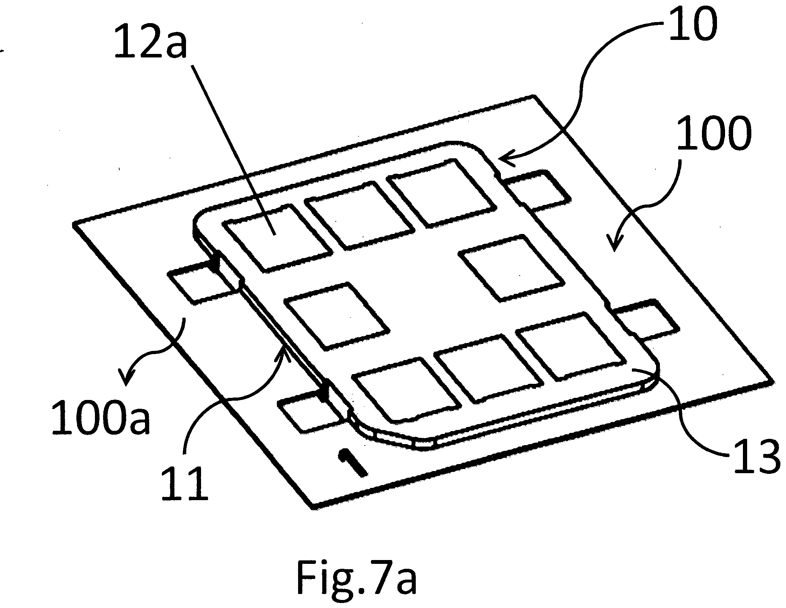

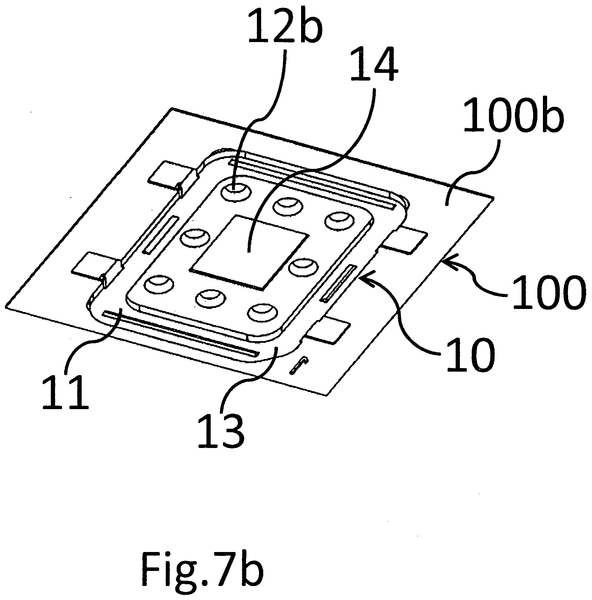

Nach der wie vorstehend beschrieben und durchgeführten Ausbildung der Lead-Frames 11 der Smartcard-Körper 10 werden auf der in den Figuren 1 und 2 sichtbaren ersten Oberfläche 100a des Trägermaterials 100 erste Kontaktflächen 12a und auf der dieser ersten Oberfläche 100a gegenüberliegenden zweiten Oberfläche 100b zweite Kontaktflächen 12b (siehe Figuren 7a und 7b) ausgebildet, indem das Trägermaterial 100 zumindest an den Stellen der Kontaktflächen 12a, 12b mit einem leitfähigen Material versehen wird. Dies kann z. B. durch Galvanisieren, Aufdampfen, Sputtern oder ähnliche Verfahren erfolgen. Auch dieser Verfahrensschritt ist bekannt und wird daher nicht mehr im Detail beschrieben.

Die auf der zweiten Oberfläche 100b des Trägermaterials 100 angeordneten Kontaktflächen 12b dienen zur Verbindung von Anschlüssen des in den Smartcard-Körper 10 einzusetzenden Halbleiter-Chips und die ersten Kontaktflächen 12a dienen zur elektrischen Verbindung der aus dem Smartcard-Körper 10 hergestellten Smartcard mit einer externen Komponente wie z. B. einem Mobiltelephon, eines Kartenlesers oder dergleichen. Vorzugsweise werden bei der Herstellung der Smartcard aus dem Smartcard-Körper 10 in an und für sich bekannter Art und Weise die Anschlüsse des Halbleiter-Chips mit den zweiten Kontaktflächen 12b durch einen Bond-Vorgang, einen Schweißprozess, einem Lötprozess oder der gleichen verbunden.

Wie aus der Figur 1 ersichtlich, wird in dem hier beschriebenen Ausführungsbeispiel ein vorgestanztes Trägermaterial 100 verwendet, in dem bereits entsprechenden Strukturen, aus denen dann der Lead-Frame 11 herstellbar ist, eingebracht wurden. Wie aus der Figur 2 ersichtlich, werden aus dem Trägermaterial 100 Bereiche, welche den Lead-Frame 11 mit dem Trägermaterial 100 verbinden, abgetrennt, so dass der Lead-Frame 11 im wesentlichen nurmehr über Materialstreifen 15 mit dem Trägermaterial 100 verbunden ist. Dann werden vorzugsweise die Kontaktflächen 12a in Position gebracht, indem sie - wie aus Figur 2 ersichtlich - gebogen werden.

Es ist aber auch möglich, ein nicht-vorgestanztes Trägermaterial 100 zu verwenden und dann aus diesem in an und für sich bekannter und daher nicht mehr näher beschriebenen Art und Weise die Lead-Frames 11 herzustellen. Die genaue Art und Weise der Ausbildung eines Lead-Frames 11 aus dem Trägermaterial 100 sowie eventuell weitere vor der Herstellung eines den Lead-Frame 11 umgebenden Gehäuses 13 durchzuführende Maßnahmen sind dem Fachmann bekannt und daher für das Verständnis der nachfolgenden Beschreibung nicht erforderlich. Es wird daher von einer detaillierten Erläuterung dieses Teils des Herstellungsprozesses des Lead-Frames 11 abgesehen.

Bevor aber nun ein Umspritzen des Lead-Frames 11 mit einem Kunststoffmaterial zur Ausbildung des den Halbleiter-Chip aufnehmenden Gehäuses 13 erfolgt, ist vorgesehen, dass die den Lead-Frame 11 mit dem Trägermaterial 100 verbindenden Materialstreifen 15 durchtrennt werden, so dass zwischen den mit dem Trägermaterial 100 verbundenen Streifenteil 15a des jeweiligen Materialstreifens 15 und den mit dem Lead-Frame 11 verbundenen Streifenteil 15b dieses Materialstreifens 15 ein Zwischenraum 16 geschaffen wird, welcher die beiden Streifenteile 15a, 15b elektrisch isoliert. Vorzugsweise erfolgt dies dadurch, dass die Materialstreifen 15 vor, während oder nach dem Durchtrennen verformt werden, so dass dadurch der Zwischenraum 16 ausgebildet wird.

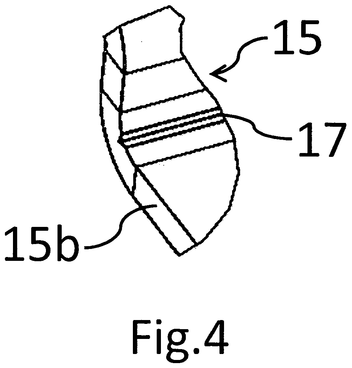

Im hier beschriebenen Ausführungsbeispiel werden - wie am besten aus Figur 4 ersichtlich - die mit dem Lead-Frame 11 verbundenen Streifenteile 15b der Materialstreifen 15 entsprechend verformt, so dass ihre Enden von den Enden der Streifenteile 15a räumlich separiert und dadurch der Zwischenraum 16 ausgebildet wird. Es ist natürlich auch möglich, dass eine entsprechende Verformung an den Streifenteilen 15a der Materialstreifen 15 durchgeführt wird. Auch ist es möglich, dass zumindest bei einem oder mehreren Materialstreifen 15 beide Streifenteile 15a, 15b zur Ausbildung des Zwischenraums 16 entsprechend verformt werden. Es ist aber auch möglich, anstelle der Verformung einen Materialstreifen 15 eine andere Art und Weise vorzusehen, um die beiden Streifenteile 15a, 15b der jeweiligen Materialstreifen 15 zu separieren und damit elektrisch zu isolieren. Zum Beispiel ist es auch möglich, dass aus einem oder mehreren der Materialstreifen 15 ein kurzes Stück herausgestanzt wird, so dass in diesem Fall eine Verformung nicht erforderlich ist. Im folgenden wird aber davon ausgegangen, dass die Materialstreifen 15 verformt werden, da dies die bevorzugte Ausgestaltung des Verfahrens ist.

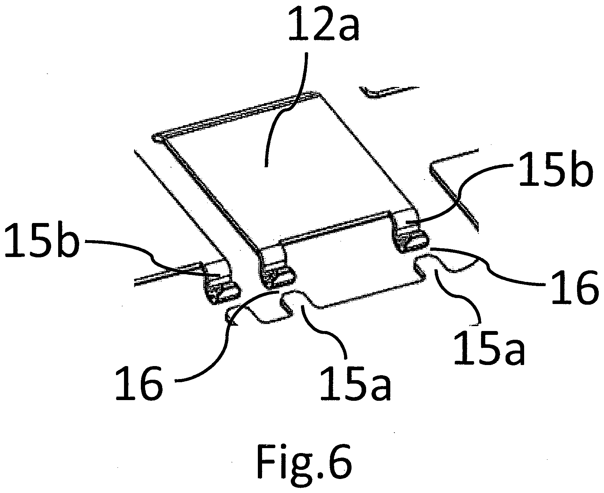

In Figur 6 sind nun derart ausgebildete Materialstreifen 15 dargestellt. Man erkennt deutlich die Zwischenräume 16, welche die Streifenteile 15a, 15b der dort dargestellten zwei Materialstreifen 15 separieren und dadurch elektrisch isolieren.

Um den Verformungsvorgang der Materialstreifen 15 zu erleichtern, kann vorzugsweise vorgesehen sein, dass - wie aus der Figur 4 ersichtlich - in einen oder mehrere Materialstreifen 15 eine Kerbe 17 eingeprägt wird, die ein Verformen des oder der Materialstreifen 15 ermöglicht.

Nachdem die Materialstreifen 15 wie vorstehend beschrieben und in Figur 6 dargestellt zur Ausbildung der Zwischenräume 16 verformt wurden, wird dann das Gehäuse 13 ausgebildet, und zwar dadurch, dass der Lead-Frame 11 mit einem isolierenden Spritzguss-Material umspritzt wird. Das Gehäuse 13 bildet sowohl um die ersten wie auch um die zweiten Kontaktflächen 12a, 12b jeweils einen umlaufenden Rand des Smartcard-Körpers 10 aus.

Die Figuren 7a und 7b zeigen nun den Smartcard-Körper 10 mit dem wie vorstehend beschrieben hergestellten Gehäuse 13. Die Figur 7a zeigt hierbei die Kontaktflächen 12a, welche zur Kontaktierung der aus dem Smartcard-Körper 10 hergestellten Smartcard mit einer externen Komponente dienen. Die Figur 7b zeigt die Bond-Seite des Smartcard-Körpers. Man erkennt deutlich eine Kavität 14, in der später der Halbleiter-Chip eingesetzt wird.

Der derart gebildete Smartcard-Körper 10 entspricht vorzugsweise der Form einer 4FF-Smarcard. Das beschriebene Verfahren ist aber nicht auf die Herstellung von 4FF-Smartcard-Körper 11 beschränkt. Es ist aber auch möglich, mit dem beschrieben Verfahren 1 FF, 2FF oder 3FF-Smartcard-Körper herzustellen, um nur einige Anwendungsbeispiele des beschriebenen Verfahrens zu nennen.

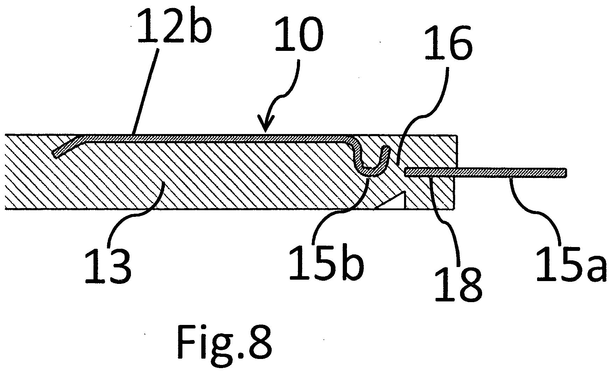

Wie am besten aus Figur 8 ersichtlich ist, wird das Gehäuse 13 dabei derart ausgebildet, dass es sowohl die ersten Streifenteile 15a der Materialstreifen 15 als auch die zweiten Streifenteile 15b derselben umfasst. Der Smartcard-Körper 10 wird somit im Trägermaterial 100 durch die vom Gehäuse 13 bewirkte mechanische Verbindung zwischen den ersten Streifenteilen 15a und den zweiten Streifenteilen 15b der Materialstreifen 15 gehalten.

Der Verwender der derart hergestellten Smartcard-Körper 10 fügt nun in an und für sich bekannter Art und Weise in die jeweilige Kavität 14 der Smartcard-Körper 10 den entsprechenden Halbleiter-Chip ein, verbindet dessen Anschlüsse mit den Kontaktflächen 12b und verschließt die den Halbleiter-Chip ausnehmende Kavität 14, wodurch aus dem Smartcard-Körper 10 und dem Halbleiter-Chip eine Smartcard hergestellt wird.

Um nun die Smartcard aus dem Trägermaterial 100 entnehmen zu können, ist es in vorteilhafter Art und Weise lediglich erforderlich, dass die Smartcard aus dem Trägermaterial 100 herausgedrückt wird. Eine Beaufschlagung des Smartcard-Körpers 10 führt dazu, dass die Streifenteile 15a der Materialstreifen 15 aus dem Gehäuse 13 herausgezogen werden. Im Gehäuse 13 bleiben somit nur die in Figur 8 ersichtlichen Ausnehmungen 18 zurück, welche vor dem Heraustrennen der Smartcard aus dem Trägermaterial 100 die Streifenteile 15b der Materialstreifen 15 aufgenommen haben. Das Herauslösen der Smartcards aus dem Trägermaterial 100 ist somit ohne einen weiteren Trennvorgang möglich. Diese Vorgangsweise besitzt den weiteren Vorteil, dass aus dem Smartcard-Körper 10 somit der aus dieser hergestellten Smartcard keine Materialstreifen des Trägermaterials 100 hervorstehen, welche Korrosionsstellen ausbilden könnten.

Zusammenfassend ist festzuhalten, dass durch das beschriebene Verfahren ein Smartcard-Körper 10 ausgebildet wird, der sich dadurch auszeichnet, dass er und somit die aus ihm hergestellte Smartcard leicht und ohne einen weiteren Trennvorgang aus dem ihn aufnehmenden Trägermaterial 100 herausgetrennt werden kann, wobei in vorteilhafter Art und Weise der Lead-Frame 11 isoliert im Gehäuse 13 aufgenommen ist, so dass die aus dem Smartcard-Körper 10 hergestellte Smartcard über keine korrosionsanfälligen Stellen verfügt.

## Patentansprüche

1. Verfahren zur Herstellung eines Smartcard-Körpers zur Aufnahme eines Halbleiter-Chips, wobei aus einem Trägermaterial (100) mindestens ein Lead-Frame (11) des Smartcard-Körpers (10) ausgebildet wird, der jeweils über mindestens einen Materialstreifen (15) mit dem Trägermaterial (100) verbunden ist, und bei dem ein elektrisch isolierendes Gehäuse (13) mit einer Kavität (14) zur Aufnahme des Halbleiter-Chips ausgebildet wird, indem der Lead-Frame (11) zur Ausbildung des Smartcard-Körpers (10) mit dem Gehäuse (13) umgeben wird, **dadurch gekennzeichnet, dass** vor oder während der Ausbildung des Gehäuses (13) der oder die den Lead-Frame (11) mit dem Trägermaterial (100) verbindenden Materialstreifen (15) durchtrennt werden, wodurch der oder die Materialstreifen (15) jeweils in einen mit dem Trägermaterial (100) verbundenen ersten Streifenteil (15a) und einen mit dem Lead-Frame (11) verbundenen zweiten Streifenteil (15b) unter Ausbildung eines Zwischenraums (16) separiert wird, und dass bei der Ausbildung des Gehäuses (13) jeweils sowohl der erste Streifenteil (15a) als auch der zweiten Streifenteil (15b) des oder der Materialstreifen (15) vom Gehäuse (13) umfasst wird.

2. Verfahren nach Anspruch 1, **dadurch gekennzeichnet, dass** zur Ausbildung des Zwischenraums (16) eine Verformung des zweiten Streifenteils (15b) und/oder des ersten Streifenteils (15a) mindestens eines Materialstreifens (15) durchgeführt wird.

3. Verfahren nach Anspruch 2, **dadurch gekennzeichnet, dass** der zweite Streifenteil (15b) und/oder der erste Streifenteil (15a) zur Ausbildung des Zwischenraums (14) gebogen wird.

4. Verfahren nach Anspruch 2 oder 3, **dadurch gekennzeichnet, dass** in mindestens einem Streifenteil (15a, 15b) eine Prägung (17) eingebracht wird.

5. Verfahren nach einem der vorangehenden Ansprüche, **dadurch gekennzeichnet, dass** an der ersten Oberfläche (100b) des Trägermaterials (100) mindestens eine erste Kontaktfläche (12a) und einer an einer dieser ersten Oberfläche (100a) gegenüberliegenden zweiten Oberfläche (100b) mindestens eine zweite Kontaktfläche (12b) des Lead-Frames (11) ausgebildet wird.

6. Verfahren nach einem der vorangehenden Ansprüche, **dadurch gekennzeichnet, dass** eine Vielzahl von Smartcard-Körpern (10) auf dem Trägermaterial (100) hergestellt und von diesem trennbar sind, wobei vorzugsweise als Trägermaterial (100) ein vorgestanztes Trägermaterial verwendet wird.

7. Verfahren zur Herstellung einer Smartcard, **dadurch gekennzeichnet, dass** in einem nach einem der vorangehenden Ansprüche hergestellten Smartcard-Körper (10), der mindestens einen Lead-Frame (11) mit einer ersten Oberfläche (100a) mit ersten Kontaktflächen (12a) und eine zweite Oberfläche (100b) mit zweiten Kontaktflächen (12b) aufweist, die mit den Anschlüssen eines in eine Kavität (14) des Smartcard-Körpers (10) eingesetzten Halbleiter-Chips verbindbar sind, der Halbleiter-Chip in die Kavität (14) des Smartcard-Körpers (10) eingebracht, dessen Anschlüsse elektrisch mit den zweiten Kontaktflächen (12b) verbunden werden und die Kavität (14) verschlossen wird, und dass durch eine Kraftbeaufschlagung der derart hergestellten Smartcard diese aus dem Trägermaterial (100) gelöst wird, indem durch diese Kraftbeaufschlagung die den Smartcard-Körper (10) mit dem Trägermaterial (100) verbindende ersten Streifenteile (15a) aus dem Gehäuse (13) des Smartcard-Körpers (10) gelöst werden.

8. Smartcard-Körper zur Aufnahme eines Halbleiter-Chips, wobei der Smartcard-Körper mindestens einen aus einem Trägermaterial (100) ausgebildeten Lead-Frame (11), der jeweils über einen Materialstreifen (15) mit dem Trägermaterial (100) verbunden ist, und der an einer ersten Oberfläche (100a) erste Kontaktflächen (12a) und einer zweiten Oberfläche (100b) zweite Kontaktflächen (12b) besitzt, aufweist, die mit den Anschlüssen eines in eine Kavität (14) des Smartcard-Körpers (10) eingesetzten Halbleiter-Chips verbindbar sind, wobei der Smartcard-Körper ein elektrisch isolierendes Gehäuse (13) besitzt, welches die Kavität (14) zur Aufnahme des Halbleiter-Chips aufweist, **dadurch gekennzeichnet, dass** der Smartcard-Körper (10) mindestens einen Materialstreifen (15) mit einem ersten Streifenteil (15a) und einen von diesem durch einen Zwischenraum (16) getrennten zweiten Streifenteil (15b) aufweist, wobei der zweite Streifenteil (15b) mit dem Lead-Frame (11) des Smartcard-Körpers (10) und der erste Streifenteil (15a) mit dem Trägermaterial (100) verbunden ist, und dass das Gehäuse (13) des Smartcard-Körpers (10) den ersten Streifenteil (15a) und den zweiten Streifenteil (15b) umschließt.

9. Smartcard umfassend einen Halbleiter-Chip und einen Smartcard-Körper (10) nach Anspruch 8, wobei der Halbleiter-Chip in die Kavität (14) des Smartcard-Körpers (10) eingesetzt ist.

## Claims

1. A method for producing a smart card body receiving a semiconductor chip, wherein in a carrier material (100) at least one lead frame (11) of the smart card body (10) is formed, said smart card body (10) being connected to the carrier material (100) via at least one material strip (15), and in which an electrically insulating casing (13) with a cavity (14) for receiving the semiconductor chip, is formed by surrounding the lead frame (11) with the casing (13), **characterized in that**, before or during the forming of the casing (13) the one material strip or the material strips (15) connecting the lead frame (11) with the carrier material (100) are separated, so that the one material strip or the material strips (15) are separated into a first strip part (15a) connected with the carrier material (100) and a second strip part (15b) connected with the lead frame (11), respectively, thereby forming an interspace (16), and that when forming the casing (13) the first strip part (15a) as well as the second strip part (15b), respectively, of the one or the material strips (15) are comprised by the casing (13).

2. A method according to claim 1, **characterized in that** for forming the interspace (16) a deformation of at least one of second strip part (15b) and of the first strip part (15a) of at least one material strip (15) is performed.

3. A method according to claim 2, **characterized in that** at least one the second strip part (15b) and the first strip part (15a) is bent to form the interspace (16).

4. A method according to claim 2 or 3, **characterized in that** a stamp (17) is introduced in at least one strip part (15a, 15b).

5. A method according to one of the previous claims, **characterized in that** at least one first contact area (12a) is formed on the first surface (100b) of the carrier material (100) and at least one second contact area (12b) of the lead frame (11) is formed on the second surface (100b) opposite to this first surface (100a).

6. A method according to one of the previous claims, **characterized in that**, a plurality of smart card bodies (10) are manufactured in the carrier material (100) and are detachable from the carrier material (100), wherein preferably a carrier material is used as carrier material (100).

7. A method for manufacturing a smart card, **characterized in that** in a smart card body (10) manufactured according to one of the previous claims a semiconductor chip is inserted in a cavity (14) of said smart card body (10) its connections are electrically connected with the second contact areas (12b) and the cavity (14) is closed, and that the smart card is detached from the carrier material (100) by impacting on the thus manufactured smart card, **in that** by this impact the strip parts (15a) connecting the smart card body (10) with the carrier material (100) are detached from the casing (13) of the smart card body (10).

8. A smart card body for receiving a semiconductor chip, wherein the smart card body (10) has at least one lead frame (11) formed by a carrier material (100), which is connected by material strips (15) with the carrier material (100), which has on a first surface (100a) first contact areas (12a) and on a second surface (100b) second contact areas (12b), which are connectable with the connections of a semiconductor chip received in a cavity (14) of the smart card body (10), the smart card body having an electrically insulating casing (13) which comprises the cavity (14) **characterized in that** the smart card body (10) comprises at least one material strip (15) with a first strip part (15a) and a second strip part (15b) separated from the first strip part (15b) by a interspace (16), wherein the second strip part (15b) is connected with the lead frame (11) of the smart card body (10) and the first strip part (15a) is connected with the carrier material (100), and that the casing (13) of the smart card body (10) encloses the first strip part (15a) and the second strip part (15b).

9. A smart card comprising a semiconductor chip and a smart card body (10) according to claim 8, wherein the semiconductor chip is received in the cavity (14) of the smart card body (10).

## Revendications

1. Procédé servant à fabriquer un corps de carte à puce servant à loger une puce à semi-conducteurs, dans lequel au moins une grille de connexion (11) du corps de carte à puce (10) est réalisée à partir d'un matériau de support (100), lequel corps de carte à puce est relié respectivement par l'intermédiaire au moins d'une bande de matériau (15) au matériau de support (100), et selon lequel un boîtier (13) à isolation électrique est réalisé avec une cavité (14) servant à loger une puce à semi-conducteurs en ce que la grille de connexion (11) servant à réaliser le corps de carte à puce (10) est entourée du boîtier (13), **caractérisé en ce qu'**avant ou au cours de la réalisation du boîtier (13), la ou les bandes de matériau (15) reliant la grille de connexion (11) au matériau de support (100) sont séparées, séparant ainsi la ou les bandes de matériau (15) respectivement en une première partie de bande (15a) reliée au matériau de support (100) et en une deuxième partie de bande (15b) reliée à la grille de connexion (11) en réalisant un espace intermédiaire (16), et **en ce que** lors de la réalisation du boîtier (13), respectivement aussi bien la première partie de bande (15a) que la deuxième partie de bande (15b) de la ou des bandes de matériau (15) sont comprises par le boîtier (13).

2. Procédé selon la revendication 1, **caractérisé en ce qu'**une déformation de la deuxième partie de bande (15b) et/ou de la première partie de bande (15a) au moins d'une bande de matériau (15) est réalisée aux fins de la réalisation de l'espace intermédiaire (16).

3. Procédé selon la revendication 2, **caractérisé en ce que** la deuxième partie de bande (15b) et/ou la première partie de bande (15a) sont pliées afin de réaliser l'espace intermédiaire (14).

4. Procédé selon la revendication 2 ou 3, **caractérisé en ce qu'**un estampage (17) est pratiqué dans au moins une partie de bande (15a, 15b).

5. Procédé selon l'une quelconque des revendications précédentes, **caractérisé en ce que** sont réalisées au moins une première surface de contact (12a) au niveau de la première surface (100b) du matériau de support (100) et au moins une deuxième surface de contact (12b) de la grille de connexion (11) au niveau d'une deuxième surface (100b) faisant face à ladite première surface (100a).

6. Procédé selon l'une quelconque des revendications précédentes, **caractérisé en ce qu'**une pluralité de corps de carte à puce (10) sont fabriqués sur le matériau de support (100) et peuvent être séparés de ce dernier, dans lequel un matériau de support préalablement estampé est utilisé de préférence en tant que matériau de support (100).

7. Procédé servant à fabriquer une carte à puce, **caractérisé en ce que** dans un corps de carte à puce (10) fabriqué selon l'une quelconque des revendications précédentes, lequel présente au moins une grille de connexion (11) pourvu d'une première surface (100a) comprenant des premières surfaces de contact (12a) et une deuxième surface (100b) pourvue de deuxièmes surfaces de contact (12b), qui peuvent être reliées aux bornes d'une puce à semi-conducteurs insérée dans une cavité (14) du corps de carte à puce (10), **en ce que** la carte à puce à semi-conducteurs est insérée dans la cavité (14) du corps de carte à puce (10), dont les bornes sont reliées de manière électrique aux deuxièmes surfaces de contact (12b) et la cavité (14) est fermée, et **en ce que** du fait de l'application d'une force sur la carte à puce fabriquée de cette manière, cette dernière est détachée du matériau de support (100) **en ce que** du fait de ladite application de force, les premières parties de bande (15a) reliant le corps de carte à puce (10) au matériau de support (100) sont détachées du boîtier (13) du corps de carte à puce (10).

8. Corps de carte à puce servant à loger une puce à semi-conducteurs, dans lequel le corps de carte à puce présente au moins une grille de connexion (11) réalisée à partir du matériau de support (100), laquelle est reliée respectivement par l'intermédiaire d'une bande de matériau (15) au matériau de support (100) et qui possède, au niveau d'une première surface (100a), des premières surfaces de contact (12a), et au niveau d'une deuxième surface (100b), des deuxièmes surfaces de contact (12b), lesquelles peuvent être reliées aux bornes d'une carte à puce à semi-conducteurs insérée dans une cavité (14) du corps de carte à puce (10), dans lequel le corps de carte à puce possède un boîtier (13) à isolation électrique, qui présente la cavité (14) servant à loger la puce à semi-conducteurs, **caractérisé en ce que** le corps de carte à puce (10) présente au moins une bande de matériau (15) pourvue d'une première partie de bande (15a) et d'une deuxième partie de bande (15b) séparée de cette dernière par un espace intermédiaire (16), dans lequel la deuxième partie de bande (15b) est reliée à la grille de connexion (11) du corps de carte à puce (10) et la première partie de bande (15a) est reliée au matériau de support (100), et **en ce que** le boîtier (13) du corps de carte à puce (10) renferme la première partie de bande (15a) et la deuxième partie de bande (15b).

9. Carte à puce comprenant une puce à semi-conducteurs et un corps de carte à puce (10) selon la revendication 8, dans laquelle la puce à semi-conducteurs est insérée dans la cavité (14) du corps de carte à puce (10).
